# EUROPEAN PATENT APPLICATION

(11) **EP 0 563 539 A1**
(43) Date of publication of application: **06.10.1993**
(21) Application number: 93101754.5
(22) Date of filing: 04.02.1993
(51) Int. Cl.: H01L 33/00

(54) **Linearizing emitted light intensity from a light-emitting device**

(30) Priority: 27.02.1992 JP 41762/92
(71) Applicant: EASTMAN KODAK COMPANY, Rochester, New York 14650-2201 (US)
(72) Inventor: Tanaka, Yukio, c/o EASTMAN KODAK COMPANY, Rochester, New York 14650-2201 (US)
(74) Representative: Wagner, Karl H., Dipl.-Ing.

(57) **Abstract**

A light-emitting device in which a separate depletion control electrode causes the increase in light intensity to be linear with respect to the increase in current, thereby facilitating control of the light intensity.

## Description

### BACKGROUND OF THE INVENTION

### Field of the Invention

The present invention relates to a light-emitting device, and more particularly to a surface emitting type light-emitting device.

### Description of the Prior Art

Small, light, light-emitting devices are extensively used in various fields. In recent years, light-emitting devices are also used in optical printers that use a beam of light to record information, in image and bar-code reading systems that utilize the intensity of a reflected beam of light, and in optical communications devices that utilize optical signals.

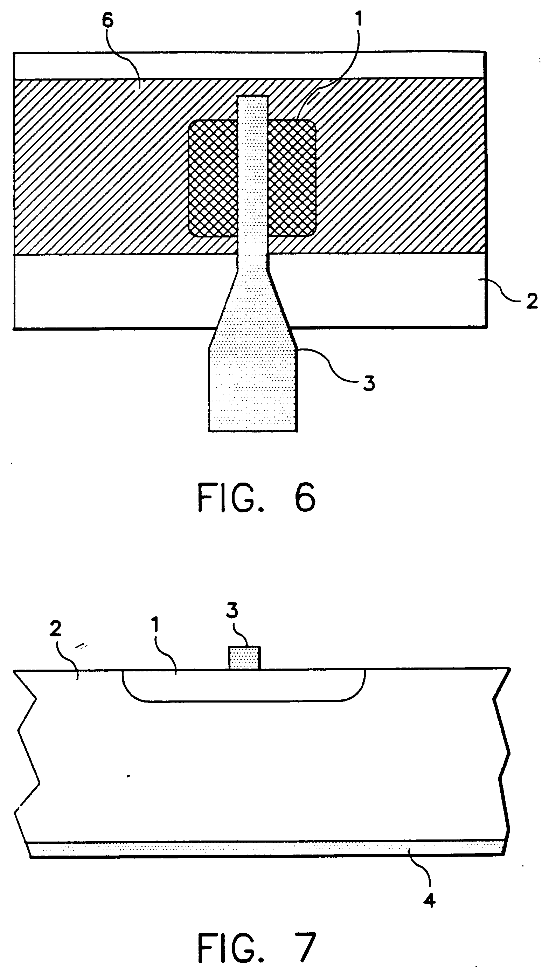

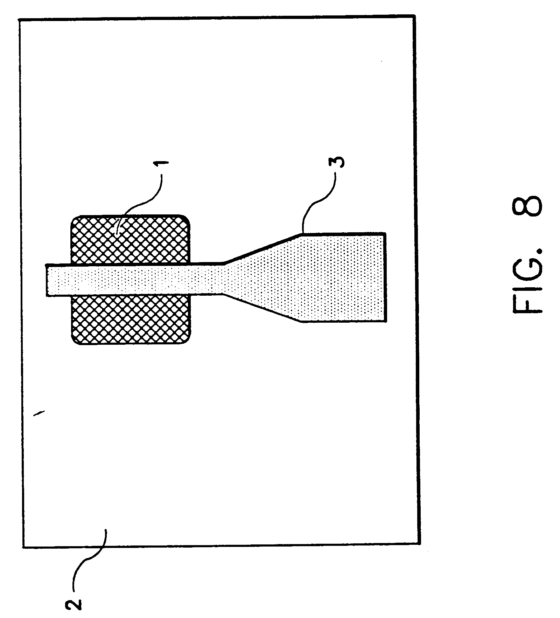

Figure 7 is a cross-sectional view of the structure of a conventional light-emitting device, and Figure 8 is a plan view of such device. With reference to the drawings, GaAsP containing tellurium is used to form an n-type semiconductor 2. Zinc is diffused into the n-type semiconductor 2 to form p-GaAsP semiconductor (hereinafter referred to as p-type semiconductor 1). A positive electrode (p-electrode) 3 is then provided on the upper surface of the p-type semiconductor 1 and a negative electrode (n-electrode) 4 on the lower surface of the n-type semiconductor 2. When a forwardly biased voltage is applied to the junction between the p-type semiconductor 1 and the n-type semiconductor 2, the electrical energy is converted into optical energy by the recombination of the carriers injected into the junction, producing an emission of light.

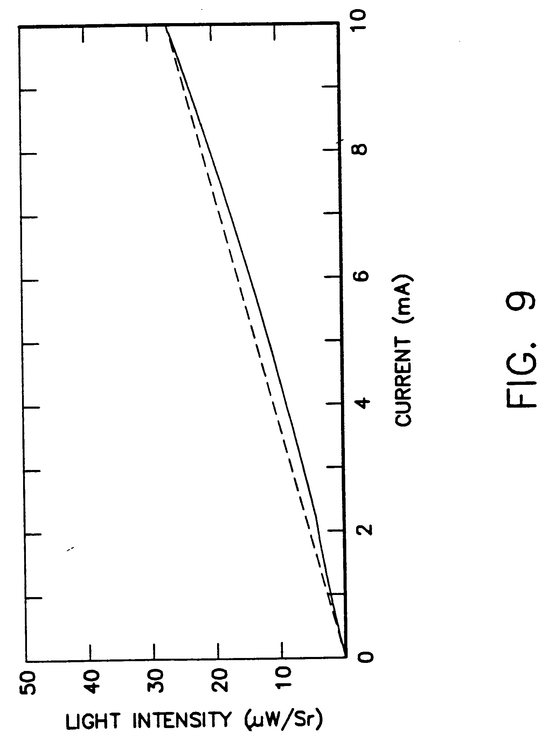

However, when a forwardly biased voltage is applied to a p-n junction, the relationship between the current flowing in the light-emitting device and the optical output is as shown by the solid line in the graph of Figure 9. The dotted line has a linear relationship between optical output and light. Namely, while the optical output increases when the current is increased, in low current regions this increase is nonlinear and depends strongly on the current. That is, when a voltage V is applied to the p-n junction, the device current is divided into a component that is proportional to exp(eV/kT) (hereinafter referred to as the type A current component) and a component that is proportional to exp(eV/2kT) (hereinafter referred to as the type B current component). In this case, the intensity of light emitted by the light-emitting device is proportional to the type A current component current.

Since in a high current region the type A current component accounts for the major portion of the total current, the intensity of light emitted by the light-emitting device is proportional to the type A current component and the increase in the light intensity is linear with respect to the increase in the device current.

That is, when there is a large current there is a linear relationship between optical output and current that has little dependence on the current, but when the current is small the type B current component occupies a relatively large proportion and the relationship between the A and type B current components depends on the voltage, so the increase in light intensity relative to the increase in current becomes nonlinear. The type B current component current consists mainly of electron and hole recombinations which occur in the depletion layer in the vicinity of the p-n junction exposed on the device surface.

In a light-emitting device, an increase in light intensity that is nonlinear with respect to the increase in current presents problems when it comes to using the current to control the light intensity, as it becomes difficult to control the light intensity when such light-emitting devices are used as light sources in optical printers, image readers and optical communications devices.

### SUMMARY OF THE INVENTION

An object of the present invention is therefore to provide a light-emitting device in which the increase in light intensity is linear with respect to the increase in current, thereby facilitating control of the light intensity when the light-emitting device is used in various devices.

In accordance with the present invention, in a light-emitting device comprising a p-n junction formed between a p-type semiconductor and an n-type semiconductor in which light emission is produced by applying a forwardly-biased voltage across electrodes, this object is attained, in the first place, by applying a positive or negative electrical field to the p-n junction portion that is exposed on the surface. The object is also attained, in the second place, by a light-emitting device thus constituted as described above, wherein the surface of the device has a nonconductive layer, and a second electrode is provided above the p-n junction via the nonconductive layer; and in the third place the object is attained by the same configuration in which the second electrode is transparent.

In this invention, by forming a depletion layer control electrode for applying a positive or negative electrical field above the p-n junction on a nonconductive layer provided on the surface of the light-emitting device and shifting the depletion layer in the vicinity of the p-n junction exposed on the surface of the device to the center portion of the semiconductor, the area of the depletion layer surface exposed on the surface of the semiconductor is decreased and electron and hole recombinations occurring in the depletion region in the vicinity of the p-n junction are suppressed, thereby suppressing the generation of current components that do not contribute to light emission, as a result of which the increase in light intensity that accompanies an increase in the device current becomes linear.

Further features of the invention, its nature and various advantages will become more apparent from the accompanying drawings and following detailed description of the invention.

### BRIEF DESCRIPTION OF THE DRAWINGS

Figure 1 is a cross-sectional view of a light-emitting device according to a first embodiment of the present invention;
Figure 2 is a plan view of a light-emitting device according to this invention;
Figure 3 is a drawing for explaining the distribution of the depletion layer when no voltage is applied to the depletion layer control electrode in a light-emitting device according to this invention;
Figure 4 is a drawing for explaining the distribution of the depletion layer when a voltage is applied to the depletion layer control electrode of the light-emitting device;
Figure 5 is a graph showing the relationship between current and light intensity in the light-emitting device of the invention;
Figure 6 is a cross-sectional view of a light-emitting device according to a second embodiment of the present invention;
Figure 7 is a cross-sectional view of a conventional light-emitting device;
Figure 8 is a plan view of the conventional light- emitting device of Figure 7; and
Figure 9 is a graph showing the relationship between current and light intensity in the conventional light-emitting device of Figures 7 and 8.

### DESCRIPTION OF THE PREFERRED EMBODIMENT

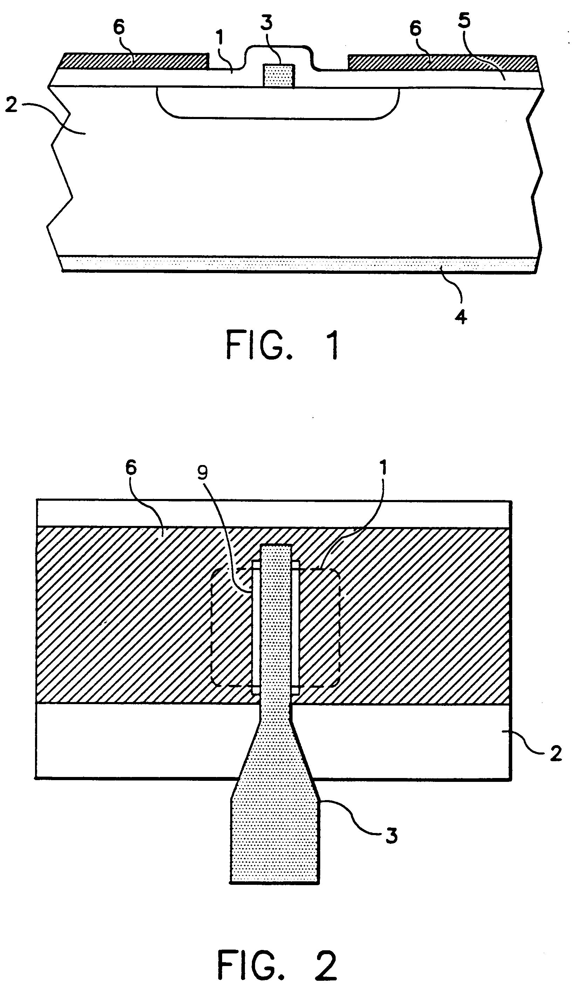

Figure 1 is a cross-sectional view of a light-emitting device according to the first embodiment of this invention. With reference to the drawing, GaAsP containing tellurium is used to form an n-type semiconductor 2, into which zinc is diffused to form a p-GaAsP semiconductor (hereinafter referred to as p-type semiconductor 1). A positive electrode (p-electrode) 3 is then formed on the upper surface of the p-type semiconductor 1 and a negative electrode (n-electrode) 4 on the lower surface of the n-type semiconductor 2.

A nonconductive layer 5 is formed on the upper surface of the p-type semiconductor 1 and n-type semiconductor 2, and on the nonconductive layer 5 a depletion layer control electrode 6 is provided over the whole of the light-emitting portion except for the central portion of the p-type semiconductor 1.

The operation of the light-emitting device thus configured will now be described. When the voltage applied to the p-n junction 8 formed by the p-type semiconductor 1 and n-type semiconductor 2 is V, the device current is divided into a component that is proportional to exp(eV/kT) (hereinafter referred to as the type A current component) and a component that is proportional to exp(eV/2kT) (hereinafter referred to as the type B current component). The intensity of light emitted by the light-emitting device is proportional to the type A current component current.

When the current is large, that is, when the voltage V is large, the type A current component accounts for the major portion of the total current. Therefore, as the intensity of light emitted by the light-emitting device is proportional to the type A current component, the light intensity will increase linearly with respect to the increase in the device current. This means that when voltage V is large, the relationship between current and optical output is constant.

However, under small current conditions, meaning when voltage V is small, it is the type B current component that accounts for a relatively large proportion of the current and the ratio between the type A and B current components therefore depends on the voltage, so the increase in light intensity resulting from an increase in the current becomes nonlinear. That is, in regions where voltage V is small the relationship between current and optical output becomes dependent on the current value. The type B current component current consists mainly of electron and hole recombinations which occur in the depletion region in the vicinity of the p-n junction exposed on the device surface. As such, the type B current component can be decreased by reducing the surface area of the depletion layer exposed on the semiconductor surface.

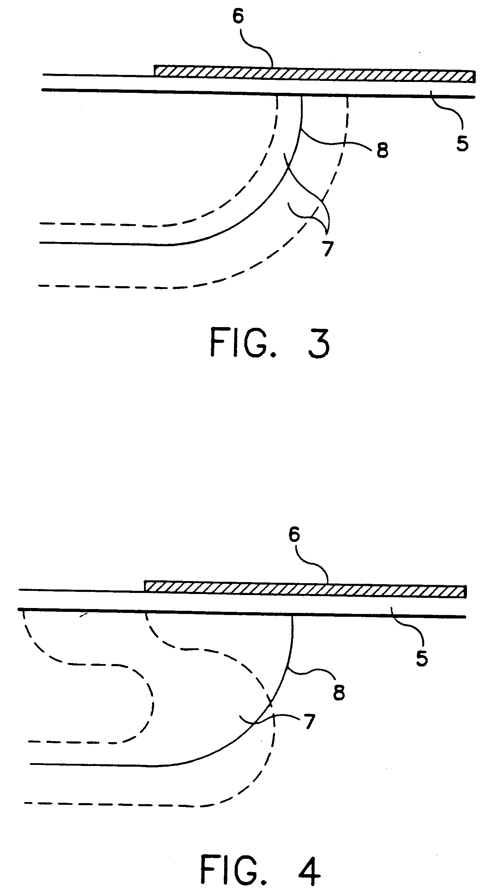

When a voltage is not being applied to the depletion layer control electrode 6 the distribution of the semiconductor p-n junction depletion layer 7 is along the periphery of the p-n junction 8, as shown in Figure 3. When a voltage is applied to the depletion layer control electrode 6 provided on the nonconductive layer 5 above the position an electric field is provided causing a change in the depletion layer since electrons are drawn to the semiconductor surface, producing the shift in the depletion layer 7 shown by Figure 4.

As shown in Figure 2, as the depletion layer control electrode 6 covers the device surface except for the central portion of the p-type semiconductor 1, if a positive voltage is applied to the depletion layer control electrode 6, the depletion layer at the semiconductor surface shifts to the central part not covered by the depletion layer control electrode 6.

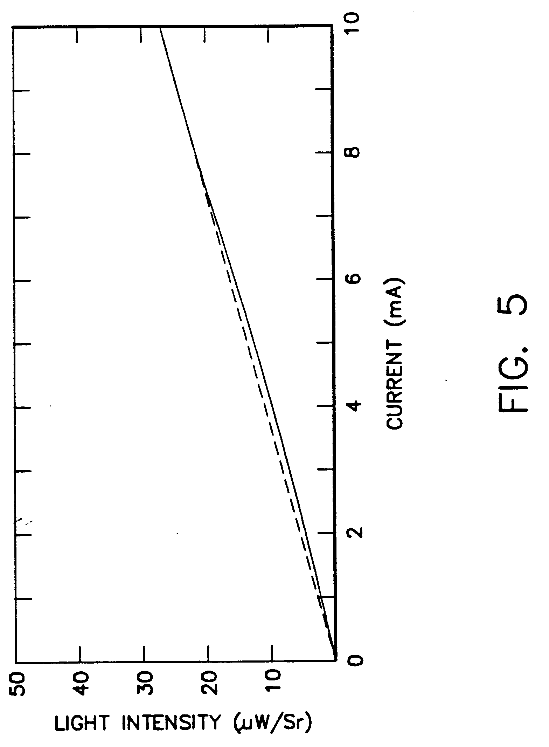

As the periphery of the portion 9 not covered by the depletion layer control electrode 6 is shorter than the periphery of the p-n junction portion that is exposed on the surface of the light-emitting device, the depletion layer region exposed on the surface becomes smaller compared to prior to the application of a positive voltage to the depletion layer control electrode 6. Therefore, if a positive voltage is applied to the depletion layer control electrode 6, the type B current component is decreased and, as shown by the solid line in the graph of Figure 5, even in low current regions a linear relationship between the increase in device current and the increase in light intensity can be achieved

Although the above embodiment has been described with reference to a light-emitting device in which the p-type semiconductor is formed on the n-type semiconductor, a light-emitting device with the same configuration may be fabricated in which it is the n-type semiconductor that is formed on the p-type semiconductor. In such a configuration, the depletion layer would be shifted by using the application of a negative voltage to the depletion layer control electrode, producing an accumulation of holes below the electrode.

Also, while in the above description GaAsP is used as the n- and p-type semiconductors, it is possible to use other compound semiconductors such as GaAs, AlAsP, Gap, and InGaP, for example.

As a second embodiment of the invention, the depletion layer control electrode may be a transparent electrode formed of InStO, tin oxide, CdStO or the like, in which case the emitted light can be output without being blocked by the depletion layer control electrode.

While in the above description the depletion layer control electrode 6 is configured so that it covers the surface of the light-emitting portion except for the central part of the p-type semiconductor 1, if the type of transparent electrode described with reference to the second embodiment is used, the same effect can be obtained even if the entire surface is covered as shown in Figure 6.

The invention has been described in detail with particular reference to certain preferred embodiments thereof, but it will be understood that variations and modifications can be effected within the spirit and scope of the invention.

## Claims

1. A light-emitting device comprising:
(a) a p-n junction formed between a p-type semiconductor and an n-type semiconductor which provides a depletion region and wherein light is produced by applying a forwardly-biased voltage across the depletion region, such forwardly applied voltage producing type A and type B current components; and
(b) depletion control means for applying an electrical field to at least a portion of the p-n junction to shift the depletion region to cause a decrease in the type B current component thereby reducing light intensity.

2. A light-emitting device according to claim 1 wherein a nonconductive layer is provided above the p-n junction, and a voltage applying electrode is provided on the non-conductive layer over at least a portion of the p-n junction.

3. A light-emitting device according to claim 2 wherein the electrode is transparent.
